# EUROPÄISCHE PATENTSCHRIFT

(11) **EP 0 601 554 B1**
(45) Veröffentlichungstag und Bekanntmachung des Hinweises auf die Patenterteilung: **18.03.1998**
(21) Anmeldenummer: 93119755.2
(22) Anmeldetag: 08.12.1993
(51) Int. Cl.: H03J 1/00

(54) **Fernsehempfangsgerät mit einer Vorrichtung zur automatischen Senderprogrammierung**
Television receiver with a device for automatic channel programming
Récepteur de télévision avec un dispositif de programmation automatique de canaux

(30) Priorität: 11.12.1992 DE 4241761
(43) Veröffentlichungstag der Anmeldung: 15.06.1994
(73) Patentinhaber: GRUNDIG Aktiengesellschaft, 90762 Fürth (DE)
(72) Erfinder: Rosenberger, Winfried, GRUNDIG E.M.V., D-90748 Fürth (DE)

(56) Entgegenhaltungen:
- GB-A- 2 208 458
- PATENT ABSTRACTS OF JAPAN vol. 14, no. 524 (E-1003)16. November 1990 & JP-A-02 222 287 (TOSHIBA CORP) 5. September 1990

## Beschreibung

Die Erfindung betrifft ein Fernsehempfangsgerät mit einer Vorrichtung zur automatischen Senderprogrammierung mit den im Oberbegriff des Anspruchs 1 angegebenen Merkmalen.

Fernsehempfänger mit einer Vorrichtung zur automatischen Senderprogrammierung sind beispielsweise bekannt aus der Zeitschrift "Funkschau" 1992, Heft 22, S. 44-46, und den Patentanmeldungen EP-A2-0 512 618, EP-A1-0 438 694, EP-A1-0 437 731 und EP-A1-0 432 736.

Bei der automatischen Senderprogrammierung werden alle Fernsehkanäle nach empfangbaren Fernsehsendern abgesucht. Dazu werden beispielsweise die von der Empfangsantenne gelieferten hochfrequenten Fernsehsignale im Tuner des Fernsehempfängers einem Mischer zugeführt und dort in eine Zwischenfrequenzlage umgesetzt. Dies geschieht unter Verwendung eines Oszillators, dessen Ausgangssignal einem Teiler mit einstellbarem Teilungsverhältnis zugeführt wird. Dieses Teilungsverhältnis wird von einem Mikrocomputer des Fernsehempfängers derart vorgegeben, daß ein schrittweises Durchsuchen aller Fernsehkanäle beispielsweise in Schritten von 1 MHz erfolgt. Während dieses schrittweisen Durchsuchens aller Fernsehkanäle nach empfangbaren Sendern wird in einer an den Ausgang des Tuners angeschlossenen Auswertungsschaltung ständig überprüft, ob das Ausgangssignal des Tuners einen vorgegebenen Mindestsignalpegel überschreitet oder nicht. Ist das der Fall, dann liegt ein empfangbarer Sender vor und das zugehörige Teilungsverhältnis für das Ausgangssignal des Oszillators wird an einem freien Speicherplatz des Senderspeichers des Fernsehempfängers abgelegt. Ferner werden - falls vorhanden - aus dem Fernsehtextdatenstrom des Senders Daten, die einer Kurzbezeichnung des Senders entsprechen, extrahiert und ebenfalls am genannten Speicherplatz abgelegt. Danach wird der Suchvorgang solange fortgesetzt, bis alle empfangbaren Sender erfaßt und die zugehörigen Daten im Senderspeicher des Fernsehempfangsgerätes abgelegt sind.

Weiterhin ist aus der US-A-4,860,380 ein Empfänger bekannt, bei welchem die im Rahmen eines automatischen Suchlaufs gefundenen und abgespeicherten Senderfrequenzen manuell durch den Benutzer um weitere Frequenzen ergänzt werden können.

Ausgehend von diesem Stand der Technik liegt der Erfindung die Aufgabe zugrunde, ein Fernsehempfangsgerät mit einer Vorrichtung zur automatischen Senderprogrammierung mit den im Oberbegriff des Anspruchs 1 angegebenen Merkmalen derart weiterzubilden, daß der Inhalt des Senderspeichers den aktuellen Empfangsverhältnissen besser angepaßt ist.

Diese Aufgabe wird bei einem Fernsehempfangsgerät mit den im Oberbegriff des Anspruchs 1 angegebenen Merkmalen durch die im kennzeichnenden Teil des Anspruchs 1 angegebenen Merkmale gelöst. Vorteilhafte Weiterbildungen der Erfindung ergeben sich aus den abhängigen Patentansprüchen.

Die Vorteile der Erfindung bestehen insbesondere darin, daß der Benutzer entweder automatisch oder nach Betätigung einer Taste der Bedieneinheit Informationen darüber erhält, ob seit der letzten automatischen Senderprogrammierung neue empfangbare Fernsehsender den Sendebetrieb aufgenommen haben oder nicht. Gegebenenfalls werden die Daten der neuen Fernsehsender automatisch in noch unbelegte Speicherplätze des Senderspeichers des Fernsehempfangsgerätes übernommen. Das bedeutet, daß die bisherige Belegung des Senderspeichers nicht verändert wird.

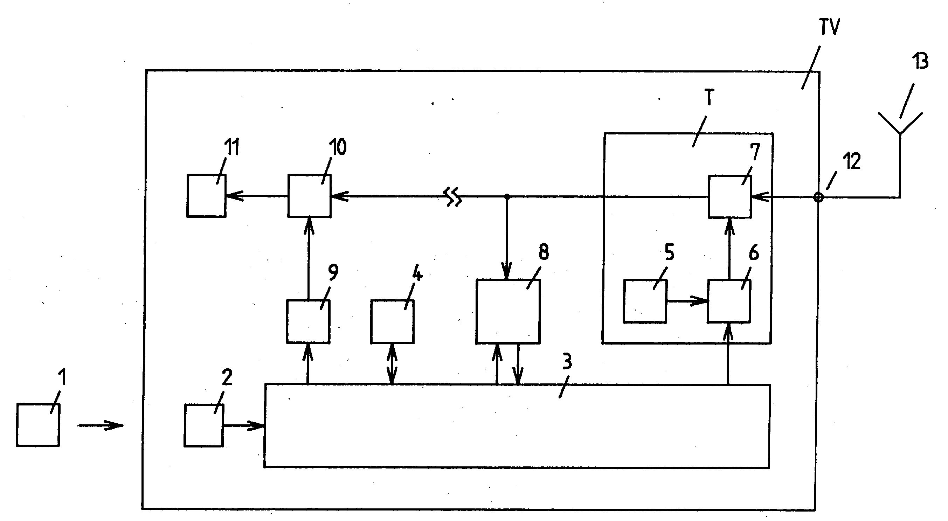

Weitere Vorteile der Erfindung ergeben sich aus der Erläuterung eines Ausführungsbeispiels anhand der Figur.

Diese zeigt einen Fernsehempfänger TV mit einem Fernbedienungsgeber 1, einem Fernbedienempfänger 2, einem Mikrocomputer 3, einem Senderspeicher 4, einem Tuner T mit einem Oszillator 5, einem Teiler 6 mit einstellbarem Teilungsverhältnis und einem Mischer 7, einer Auswertungsschaltung 8, einem Textbaustein 9, einer Eintastschaltung 10, einem Bildschirm 11, einem Antenneneingang 12 und einer Empfangsantenne 13.

Das gezeigte Fernsehempfangsgerät ist zur automatischen Senderprogrammierung in zwei Suchlaufbetriebsarten betreibbar.

Die erste Suchlaufbetriebsart wird durch Betätigung einer Taste des Fernbedienungsgebers 1 ausgelöst und wird üblicherweise im Rahmen der ersten Inbetriebnahme des Fernsehempfangsgerätes verwendet. Dabei werden die von der Empfangsantenne 13 empfangenen und dem Fernsehempfangsgerät TV über den HF-Eingang 12 zugeführten Fernsehsignale im Tuner T dem Mischer 7 zugeführt und dort in eine Zwischenfrequenzlage umgesetzt. Dies geschieht unter Verwendung des Oszillators 5, dessen Ausgangssignal einem Teiler 6 mit einstellbarem Teilungsverhältnis zugeführt wird. Dieses Teilungsverhältnis wird vom Mikrocomputer 3 derart vorgegeben, daß ein schrittweises Durchsuchen aller Fernsehkanäle beispielsweise in Schritten von 1 MHz erfolgt. Während dieses schrittweisen Durchsuchens aller Fernsehkanäle nach empfangbaren Sendern wird in der Auswertungsschaltung 8 ständig überprüft, ob das Ausgangssignal des Tuners T einen vorgegebenen Mindestsignalpegel überschreitet oder nicht. Ist das der Fall, dann liegt ein empfangbarer Sender vor und das zugehörige Teilungsverhältnis für das Ausgangssignal des Oszillators 5 wird an einem freien Speicherplatz des Senderspeichers 4 abgelegt. Weiterhin werden aus dem Fernsehtextdatenstrom des Senders Daten, die einer Kurzbezeichnung des Senders entsprechen, extrahiert und ebenfalls am genannten Speicherplatz abgelegt. Danach wird der Suchvorgang solange fortgesetzt, bis alle empfangbaren Sender erfaßt und die zugehörigen Daten im Senderspeicher 4 des Fernsehempfangsgerätes abgelegt sind.

Diese Daten werden im nächsten Schritt automatisch nach vorgegebenen Kriterien sortiert. Geeignete Kriterien sind beispielsweise übliche Zuschauergepflogenheiten, wonach beispielsweise das ARD auf Programmplatz 1 und das ZDF auf Programmplatz 2 gelegt werden, das Vorhandensein oder Fehlen von VPS-Signalen, das Vorhandensein oder Fehlen von Teletextsignalen, usw.

Nach dieser Sortierung, die mit einer automatischen Vertauschung von Speicherplätzen innerhalb des Senderspeichers 4 und damit auch einer automatischen Vertauschung von Stationstastennummern verbunden ist, sind in den einzelnen Speicherplätzen des Senderspeichers 4 in einer Reihenfolge, die von den verwendeten Sortierkriterien abhängt, den jeweiligen Sendern zugehörige Teilungsverhältnisse und für bestimmte Sender eine Senderkurzbezeichnung abgespeichert.

Diese können nach Betätigung einer Taste des Fernbedienungsgebers 1 in Tabellenform auf dem Bildschirm 11 dargestellt werden. Diese Darstellung erfolgt unter Steuerung durch den Mikrocomputer 3 unter Verwendung des Textbausteins 9 und der Eintastschaltung 10.

Um dem Benutzer zu ermöglichen, auch Sendern, deren Kurzbezeichnung in dieser Tabelle noch nicht enthalten ist, eine derartige Kurzbezeichnung zuzuordnen, wird auf dem Bildschirm 11 zusätzlich zur genannten Tabelle eine Auswahlliste von Sendernamen bzw. Senderkurzbezeichnungen zur Verfügung gestellt. Aus dieser Liste kann der Benutzer unter Verwendung eines Cursors und der Cursorsteuertasten auf dem Fernbedienungsgeber 1 eine gewünschte Senderkurzbezeichnung auswählen und in die Tabelle übernehmen.

Weiterhin kann der Benutzer in dieser Tabelle unter Verwendung des Cursors und der Cursorsteuertasten eine individuelle Veränderung der Reihenfolge der im Senderspeicher 4 abgelegten Daten und damit der den einzelnen Sendern zugeordneten Stationstastennummern vornehmen.

Die zweite Suchlaufbetriebsart wird entweder ebenfalls durch Betätigung einer Taste des Fernbedienungsgebers 1 ausgelöst, welche sich von der Taste unterscheidet, mittels der die erste Suchlaufbetriebsart ausgelöst wird, oder automatisch ausgelöst, wenn das Fernsehempfangsgerät in den Bereitschaftsbetrieb gebracht wird. Wird die zweite Suchlaufbetriebsart nach der Umschaltung des Fernsehempfangsgerätes in den Bereitschaftsbetrieb automatisch ausgelöst, dann werden in einer Art Pseudobereitschaftsbetrieb diejenigen Baugruppen des Fernsehempfangsgerätes, die zur Durchführung des Suchlaufbetriebes benötigt werden, vom Mikrocomputer 3 aktiviert und nach Beendigung des Suchlaufbetriebes wieder deaktiviert.

Bei der zweiten Suchlaufbetriebsart wird die bisherige Belegung des Senderspeichers 4 und damit die vorliegende Zuordnung zwischen den Stationstastennummern und den bisher erfaßten Fernsehsendern nicht verändert.

Um dies zu erreichen, überprüft der Mikrocomputer 3 immer dann, wenn während des Suchlaufes ein Sender ermittelt wird, ob das zugehörige Teilungsverhältnis bereits im Senderspeicher 4 abgespeichert ist oder nicht. Ist das der Fall, dann wird der Suchlauf fortgesetzt, ohne daß eine Übernahme des dem Sender zugeordneten Teilungsverhältnisses und ggfs. der Senderkurzbezeichnung in den Senderspeicher 4 erfolgt. Erkennt der Mikrocomputer 3 jedoch, daß das einem ermittelten Sender zugeordnete Teilungsverhältnis im Senderspeicher 4 noch nicht enthalten ist, dann erfolgt eine Abspeicherung an einem bisher noch nicht belegten Speicherplatz des Senderspeichers 4, wobei - falls vorhanden - eine in den Austastlücken des Fernsehsignals übertragene Senderkurzbezeichnung ebenfalls im Senderspeicher 4 abgelegt wird.

Um den Benutzer auf das Auffinden eines neuen Senders hinzuweisen, initiiert der Mikrocomputer 3 eine Anzeige. Diese Anzeige kann durch Ansteuerung einer am Fernbedienungsgeber 1 oder am Gehäuse des Fernsehempfangsgerätes TV angeordneten Leuchtdiode erfolgen. Vorzugsweise wird dem Benutzer das Auffinden eines neuen Senders jedoch dadurch signalisiert, daß der Mikrocomputer 3 den Textbaustein 9 und die Eintastschaltung 10 derart ansteuert, daß ein Hinweis in alphanumerischer Form auf dem Bildschirm 11 erfolgt.

Wurde die zweite Suchlaufbetriebsart nach der Überführung des Fernsehempfangsgerätes in den Bereitschaftsbetrieb automatisch ausgelöst, dann erfolgt die Anzeige auf dem Bildschirm nach der nächsten Umschaltung des Fernsehempfangsgerätes in den eingeschalteten Zustand.

## Patentansprüche

1. Fernsehempfangsgerät mit einer Vorrichtung zur automatischen Senderprogrammierung, die in einer ersten Suchlaufbetriebsart betreibbar ist, bei der alle Fernsehkanäle automatisch nacheinander nach empfangbaren Sendersignalen abgesucht werden und Informationen über alle ermittelten Sender im Senderspeicher des Fernsehempfangsgerätes abgelegt werden,
**dadurch gekennzeichnet,** daß die Vorrichtung zur automatischen Senderprogrammierung weiterhin in einer zweiten Suchlaufbetriebsart betreibbar ist, bei der die bestehende Belegung des Senderspeichers erhalten bleibt und Informationen über neu ermittelte Sender in weiteren Speicherplätzen des Senderspeichers abgelegt werden.

2. Fernsehempfangsgerät nach Anspruch 1,
**dadurch gekennzeichnet,** daß das Auffinden eines neuen Senders auf einer Anzeige signalisiert wird.

3. Fernsehempfangsgerät nach Anspruch 1 oder 2,
**dadurch gekennzeichnet,** daß die zweite Suchlaufbetriebsart automatisch ausgelöst wird, wenn das Fernsehempfangsgerät in den Bereitschaftsbetrieb gebracht wird.

4. Fernsehempfangsgerät nach Anspruch 3,
**dadurch gekennzeichnet,** daß das Auffinden eines neuen Senders nach der erneuten Umschaltung des Fernsehempfangsgerätes in den eingeschalteten Zustand auf dem Bildschirm signalisiert wird.

5. Fernsehempfangsgerät nach Anspruch 1 oder 2,
**dadurch gekennzeichnet,** daß die zweite Suchlaufbetriebsart mittels der Bedieneinheit des Fernsehempfangsgerätes auslösbar ist.

6. Fernsehempfangsgerät nach Anspruch 5,
**dadurch gekennzeichnet,** daß das Auffinden eines neuen Senders auf dem Bildschirm signalisiert wird.

## Claims

1. Television receiver having an automatic station programming device which can be operated in a first search mode in which all the television channels are automatically scanned consecutively for receivable station signals and items of information about all the stations found are stored in the station memory of the television receiver, characterized in that the automatic station programming device can furthermore be operated in a second search mode in which the existing contents of the station memory remain intact and items of information about newly found stations are stored in further memory locations of the station memory.

2. Television receiver according to Claim 1,
characterized in that the location of a new station is signalled on a display.

3. Television receiver according to Claim 1 or 2,
characterized in that the second search mode is automatically initiated when the television receiver is set to the standby mode.

4. Television receiver according to Claim 3,
characterized in that the location of a new station is signalled on the picture screen after the television receiver is again switched over to the switched-on state.

5. Television receiver according to Claim 1 or 2,
characterized in that the second search mode can be initiated by means of the operating unit of the television receiver.

6. Television receiver according to Claim 5,
characterized in that the location of a new station is signalled on the picture screen.

## Revendications

1. Récepteur de télévision comportant un dispositif servant à réaliser la programmation automatique d'émetteurs et qui peut fonctionner dans un premier type de fonctionnement de recherche, dans lequel des signaux d'émetteurs pouvant être reçus sont recherchés successivement, de façon automatique, dans tous les canaux de télévision et des informations concernant tous les émetteurs déterminés sont mémorisées dans la mémoire d'émetteurs du récepteur de télévision, caractérisé en ce que le dispositif de programmation automatique d'émetteurs peut fonctionner en outre dans un second type de fonctionnement de recherche, dans lequel l'occupation existante de la mémoire d'émetteurs reste conservée et des informations concernant des émetteurs nouvellement déterminés sont mémorisées en d'autres emplacements de la mémoire d'émetteurs.

2. Récepteur de télévision selon la revendication 1, caractérisé en ce que la découverte d'un nouvel émetteur est signalée sur un dispositif d'affichage.

3. Récepteur de télévision selon la revendication 1 ou 2, caractérisé en ce que le second type de fonctionnement de recherche est déclenché automatiquement lorsque le récepteur de télévision est placé dans le mode de disponibilité.

4. Récepteur de télévision selon la revendication 3, caractérisé en ce que la détection d'un nouvel émetteur après la nouvelle commutation du récepteur de télévision dans l'état activé est signalée sur l'écran.

5. Récepteur de télévision selon la revendication 1 ou 2, caractérisé en ce que le second type de fonctionnement de recherche peut être déclenché à l'aide de l'unité de commande du récepteur de télévision.

6. Récepteur de télévision selon la revendication 5, caractérisé en ce que la détection d'un nouvel émetteur est signalée sur l'écran.
